# EUROPÄISCHE PATENTSCHRIFT

(11) **EP 1 471 782 B1**
(45) Veröffentlichungstag und Bekanntmachung des Hinweises auf die Patenterteilung: **09.09.2009**
(21) Anmeldenummer: 04004163.4
(22) Anmeldetag: 25.02.2004
(51) Int. Cl.: H05K 9/00

(54) **Gehäuse für TV-Tuner für Fahrzeuge**
Housing for TV-tuner in vehicle
Boîtier pour un syntoniseur TV dans un véhicule

(30) Priorität: 11.04.2003 DE 10317035
(43) Veröffentlichungstag der Anmeldung: 27.10.2004
(73) Patentinhaber: Hirschmann Electronics GmbH & Co. KG, 72654 Neckartenzlingen (DE)
(72) Erfinder: Silva, David, 72654 Neckartenzlingen (DE)
(74) Vertreter: Thul, Hermann

(56) Entgegenhaltungen:
- WO-A-01/13695
- WO-A-94/04014
- US-A1- 2002 173 265

## Beschreibung

Die Erfindung betrifft ein Gehäuse für Hochfrequenzgeräte, insbesondere für TV-Tuner für Fahrzeuge, im Frequenzbereich oberhalb von 100 Megahertz gemäß den Merkmalen des Patentanspruchs 1.

Gehäuse für Hochfrequenzgeräte sind grundsätzlich bekannt. Diese können entweder aus Metall oder Kunststoff bestehen, wobei es für Anwendungen Im Frequenzbereich oberhalb von 100 Megahertz erforderlich ist, Gehäuse aus Metall zu verwenden, um Einstrahlungen In das Gehäuse sowie Abstrahlungen des HF-Gerätes, welches in dem Gehäuse untergebracht ist, zu verhindern. Aufgrund der elektrischen Leistungen, die von solchen Hochfrequenzgeräten Im Gehäuse umgesetzt werden und vor allen Dingen auch bei Anwendungen des Hochfrequenzgerätes im Fahrzeug entstehen für die elektronischen Schaltungen innerhalb des Gehäuses hohe Temperaturen, die schädlich sein können. Zu diesem Zweck ist es vorgesehen, daß das Gehäuse Öffnungen aufweist, über die ein Luftaustausch mit der Umgebung erfolgen kann. Meistens sind sogar noch Lüfter in dem Gehäuse angeordnet, die die natürliche Luftzirkulation unterstützen sollen.

Bei einem bekannten Gehäuse, welches im Druckgußverfahren hergestellt wird, sind die Öffnungen für den Luftaustausch als mehrere, parallel zueinander verlaufende Schlitze ausgebildet. Neben diesen Schlitzen befinden sich parallel laufende Stege aus dem Druckgußmaterial, die den ganz entscheidenden Nachteil haben, daß sie bei diesen sehr hohen Frequenzen quasi als Stabantenne fungieren. Das bedeutet, daß über diese metallischen Stäbe Hochfrequenzsignale in das Hochfrequenzgerät eingestrahlt und außerdem Hochfrequenzsignale aus dem Hochfrequenzgerät abgestrahlt werden, die zu Störungen (wie beispielsweise Interferenzen) führen.

Die gattungsbildende WO 01/13695 offenbart ein Gehäuse für Hochfreguenzgeräte, wobei das Gehäuse zumindest zweiteilig ausgebildet ist und der zumindest eine Teil des Gehäuses einen Ausschnitt aufweist, der von einem gelöcherten Einsatz verschließbar ist und der gelöcherte Bereich eine hochfreguenzmäβige Abdichtung bewirkt.

Der Erfindung liegt daher die Aufgabe zugrunde, ein Gehäuse für Hochfrequenzgeräte, insbesondere für TV-Tuner für Fahrzeuge, bereitzustellen, mit dem die eingangs geschilderten Nachtelle beseitigt werden.

Diese Aufgabe ist durch die Merkmale des Patentanspruchs 1 gelöst.

Erfindungsgemäß ist vorgesehen, daß das Gehäuse durch ein Gehäuseoberteil aus einem Druckgußmaterial und durch eine Bodenplatte gebildet ist wobei Ausschnitt in dem Gehäuseoberteil eingebracht und der gelöcherte Einsatz Bestandteil der Bodenplatte ist. Dadurch ist zunächst der Vorteil gegeben, daß das Gehäuse zum Beispiel nach wie vor im Druckguß gefertigt werden kann, wobei die Herstellung eines beispielsweise in etwa quadratischen, rechteckigen, runden oder sonstigen Ausschnittes beim Entformen bzw. bei der Herstellung der Form für den Druckguß keine Probleme bereitet. Um zu verhindern, daß über diesen Ausschnitt Teile in das Gehäuse gelangen können (da er eine Fläche beispielsweise von einigen Quadratzentimetern hat) ist es erforderlich, diesen Ausschnitt zu verschließen, so daß einerseits gewährleistet ist, daß keine Teile in das Gehäuse eindringen können und dabei die Öffnungen so gestaltet sind, daß der Verschluß des Ausschnittes keine hochfrequenten Abstrahlungen bzw. Einstrahlungen ermöglicht. Dies wird dadurch verhindert, daß der Einsatz als gelöcherter Einsatz ausgebildet ist, so daß dadurch Kühlluft zwischen Umgebung und dem Inneren des Gehäuses ausgetauscht werden kann, weiterhin verhindert wird, daß Teile in das Gehäuse eindringen können und ebenso weiterhin wirksam verhindert wird, daß Einstrahlungen bzw. Abstrahlungen über den gelöcherten Einsatz erfolgen können. Ein weiterer besonders wichtiger Vorteil des gelöcherten Einsatzes ist seine einfache Herstellung, da er auf einfache Art und Weise als Stanzteil hergestellt werden kann.

Weitere Ausgestaltungen der Erfindung, auf die diese jedoch nicht beschränkt ist, sind in den Unteransprüchen angegeben, die im folgenden anhand eines Ausführungsbeispieles beschrieben werden.

Es zeigen:
- Figur 1: Draufsicht auf ein Gehäuse,
- Figur 2: Innenansicht des Gehäuses,
- Figur 3: Gestaltung der Bodenplatte des Gehäuses.

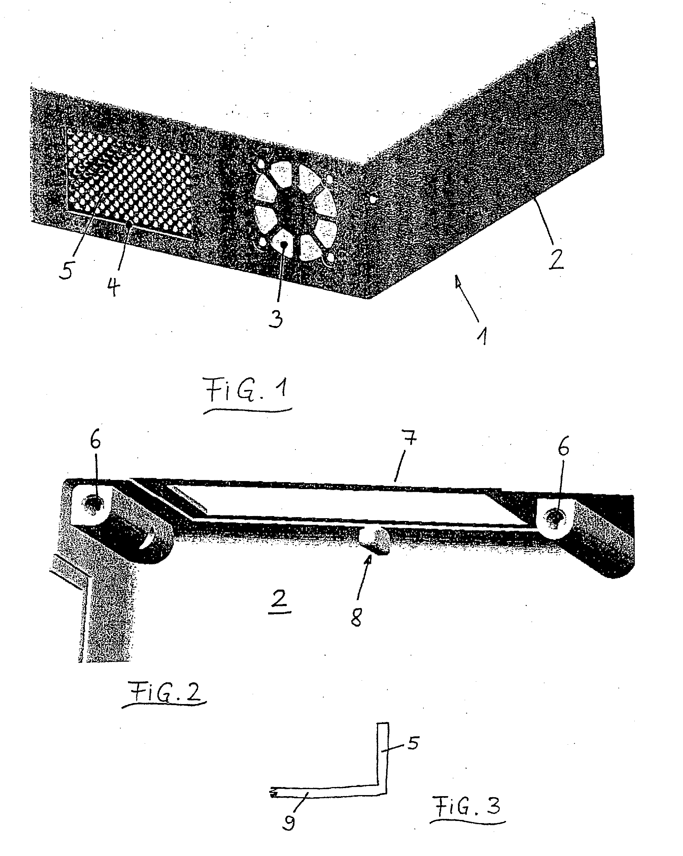

Figur 1 zeigt ein Gehäuse 1, bei dem es sich beispielsweise um ein Gehäuse für ein Hochfrequenzgerät, insbesondere für TV-Tuner für Fahrzeuge, handelt. Das Gehäuse 1 besteht aus zumindest zwei Teilen, wobei es sich bei diesen beiden Teilen um ein Gehäuseoberteil 2 und eine in Figur 1 nicht gezeigte Bodenplatte handelt. Bei diesem Ausführungsbeispiel ist das Gehäuseoberteil 2 aus einem Druckgußmaterial im Druckgußverfahren hergestellt, während die Bodenplatte als Stanz- bzw. Stanzbiegeteil hergestellt wird. Daneben ist die Herstellung des Gehäuses 1 aus anderen Materialien bzw. auf andere Art und Weise (zum Beispiel Kunststoffkern des Gehäuseoberteiles 2, der mit einer elektrisch leitenden Schicht beschichtet wird und dergleichen) denkbar.

Bei der Herstellung des Gehäuseoberteiles 2 werden Öffnungen 3 eingebracht, über die ein Innerhalb des Gehäuses 1 angeordneter Lüfter Kühlluft ansaugen kann. Dieser Lüfter kann beispielsweise direkt hinter den Öffnungen 3 angeordnet sein. Zusätzlich (oder auch nur) weist das Gehäuseobertell 2 einen Ausschnitt 4 auf, der bei diesem Ausführungsbeispiel rechteckig ausgeformt ist. Andere Gestaltungen des Ausschnittes 4 sind selbstverständlich auch denkbar und müssen nicht nur in einer Seitenwand des Gehäuses 1 angeordnet sein, sondern können auch nur im Deckelbereich oder übergreifend von Seitenwand in den Deckelbereich angeordnet sein. Wenn nur der Ausschnitt 4 vorhanden ist (und die Öffnungen 3 nicht vorhanden sind) findet der Austausch von Kühlluft nur über den Ausschnitt 4 statt. Erfindungsgemäß ist vorgesehen, daß der Ausschnitt 4 von einem gelöcherten Einsatz 5 verschlossen wird, wobei der Einsatz 5 als Stanzteil hergestellt und hinter der Seitenwand des Gehäuseoberteiles 2 angeordnet wird. Die Befestigung hier kann beispielsweise durch Verschraubung, Verklebung, Verklemmung oder dergleichen erfolgen.

Neben der schon beschriebenen Herstellung des Gehäuses 1 in einem Druckgußverfahren, bei dem der Ausschnitt 4 vorgesehen wird, ist es selbstverständlich auch denkbar, daß das Gehäuseoberteil 2 in einem Stanzbiegeverfahren hergestellt wird, wobei in einem Blech der gelöcherte Bereich vorgesehen und dann die Seitenwände zur Realisierung des Gehäuseoberteiles 2 abgewinkelt werden.

Figur 2 zeigt die Innenansicht des Gehäuseoberteiles 2, wobei in der Seitenwand des Gehäuseoberteiles 2 wieder der Ausschnitt 4 erkennbar ist. Hierbei ist erkennbar, daß ein Bereich um den Ausschnitt 4 herum im Innenbereich des Gehäuses 1 etwas zurückversetzt angeordnet ist, wobei dieser zurückgesetzte Bereich den gelöcherten Einsatz 5 aufnimmt. Dabei kann dieser Einsatz als ein Einzelteil im Stanzverfahren hergestellt und In den Ausschnitt 4 eingesetzt werden. Darüber hinaus ist es aber auch denkbar, daß der Einsatz 5 Bestandteil der Bodenplatte ist, so daß mit Einsätzen der hier nicht gezeigten Bodenplatte auf das Gehäuseoberteil 2 auch gleichzeitig der Ausschnitt 4 mit dem gelöcherten Einsatz 5 verschlossen wird. Zur Fixierung der Bodenplatte weist das Gehäuseoberteil 2 an geeigneter Stelle Verstärkungen auf, die mit Bohrungen 6 versehen sind, wobei die Bodenplatte mit den Bohrungen 6 ebenfalls korrespondierende Öffnungen aufweist, so daß damit die Bodenplatte an dem Gehäuseoberteil 2, z. B. durch Verschraubung, fixiert werden kann. Mit der Bezugsziffer 7 ist noch eine Seitenwand des Gehäuseoberteiles 2 bezeichnet, in der sich der Ausschnitt 4 befindet. Zur Lagefixierung des Einsatzes 5, insbesondere wenn dieser ein Bestandteil der Bodenplatte ist, weist das Gehäuseoberteil 2 zumindest ein Fixiermittel, insbesondere eine Nase 8, auf, mit der der Einsatz 5 beim Einsetzen in den zurückversetzten Bereich rund um den Ausschnitt 4 in der Seitenwand 7 in seiner Lage fixiert wird. Dadurch ist gewährleistet, daß der aus einem elektrisch leitenden Material bestehende Einsatz 5 in Kontakt kommt mit dem Material der Seitenwand 7 des Gehäuseoberteiles 2, so daß dadurch eine hochfrequenzdichte Verbindung erzielt wird. Außerdem ist gewährleistet, wenn beispielsweise die Nase 8 eine Abschrägung aufweist, daß der Einsatz 5 beim Einsetzen, insbesondere beim Einsetzen der Bodenplatte, geführt wird und durch den schrägen Verlauf der Nase 8 in seiner Endstellung eingeklemmt wird, so daß der Einsatz 5 fest an der Seitenwand 7 zur Anlage kommt und dadurch Geräusche vermieden werden.

Figur 3 zeigt im Schnitt eine Bodenplatte 9, die das zumindest zweite Teil des Gehäuses 1 bildet und mit der das Gehäuseoberteil 2 verschlossen ist. Der Vollständigkeit halber sei erwähnt, daß beispielsweise auf der Bodenplatte 9 die elektronische Schaltung (oder auch mehrere) des Hochfrequenzgerätes angeordnet ist (sind). Aufgrund der flächigen Formgebung der Bodenplatte 9 besteht diese in vorteilhafter Weise aus einem Blech, welches mittels Stanzen bearbeitet wird. Dabei kann bei einem der Stanzvorgänge der gelöcherte Bereich vorgesehen werden, so daß dann nach dem Einstanzen der Löcher für den hochfrequenzmäßigen Verschluß des Ausschnittes 4 dieser Bereich von der Bodenplatte 9 abgewinkeit wird, so daß der Vorteil gegeben ist, daß mit Montage der Bodenplatte 9 an dem Gehäuseoberteil 2 auch gleichzeitig der Ausschnitt 4 verschlossen wird. Bei Betrachtung der Figuren 2 und 3 wird deutlich, daß mit Einsetzen der Bodenplatte 9 der abgewinkelte Einsatz 5 entlang der zurückgesetzten Bereiche in der Seitenwand 7 geführt und durch die zumindest eine Nase 8 aufgenommen und festgesetzt wird.

### Bezugszeichenliste

- 1: Gehäuse
- 2: Gehäuseoberteil
- 3: Öffnungen
- 4: Ausschnitt
- 5: Einsatz
- 6: Bohrungen
- 7: Seitenwand
- 8: Nase
- 9: Bodenplatte

## Patentansprüche

1. Gehäuse (1) für Hochfrequenzgeräte, wobei das Gehäuse (1) zumindest zweitellig ausgebildet ist, wobei der zumindest eine Teil des Gehäuses (1) einen Ausschnitt (4) aufweist, der von einem gelöcherten Einsatz (5) für den Durchlass von Kühlluft verschließbar ist und der gelöcherte Bereich eine hochfrequenzmäßige Abdichtung bewirkt, **dadurch gekennzeichnet, daß** das Gehäuse (1) durch ein Gehäuseoberteil (2) aus einem Druckgußmaterial und durch eine Bodenplatte (9) gebildet ist, wobei der Ausschnitt (4) in dem Gehäuseoberteil (2) eingebracht und der gelöcherte Einsatz (5) Bestandteil der Bodenplatte (9) ist.

2. Gehäuses (1) nach Anspruch 1, **dadurch gekennzeichnet, daß** die Bodenplatte (9) ein Stanztell ist.

3. Gehäuse (1) nach Anspruch 1 oder 2, **dadurch gekennzeichnet, daß** der gelöcherte Einsatz (5) ein abgewinkelter Bestandteil der Bodenplatte (9) ist.

4. Gehäuse (1) nach Anspruch 1, 2 oder 3, **dadurch gekennzeichnet, daß** das Hochfrequenzgerät ein TV-Tuner für Fahrzeuge im Frequenzbereich oberhalb von 100 Megahertz ist.

## Claims

1. Housing (1) for radio-frequency appliances, with the housing (1) being in at least two parts, with the at least one part of the housing (1) having a cutout (4) which can be closed by a perforated insert (5) for cooling air to pass through, and the perforated area creating a radio-frequency seal, **characterized in that** the housing (1) is formed by a housing upper part (2), composed of a die-cast material and by a bottom plate (9), with the cutout (4) being incorporated in the housing upper part (2) and with the perforated insert (5) being a component of the bottom plate (9).

2. Housing (1) according to Claim 1, **characterized in that** the bottom plate (9) is a stamped part.

3. Housing (1) according to Claim 1 or 2, **characterized in that** the perforated insert (5) is an angled component of the bottom plate (9).

4. Housing (1) according to Claim 1, 2 or 3, **characterized in that** the radio-frequency appliance is a TV tuner, for vehicles, in the frequency range above 100 Megahertz.

## Revendications

1. Boîtier (1) pour appareils à haute fréquence, le boîtier (1) étant réalisé au moins en deux parties, au moins une partie du boîtier (1) présentant une découpe (4) qui peut être fermée par un insert perforé (5) pour laisser passer de l'air de refroidissement et la zone perforée réalisant une fermeture hermétique aux hautes fréquences, **caractérisé en ce que** le boîtier (1) est formé par une partie supérieure de boîtier (2) en matériau moulé sous pression et par une plaque de fond (9), la découpe (4) étant pratiquée dans la partie supérieure de boîtier (2) et l'insert perforé (5) faisant partie de la plaque de fond (9).

2. Boîtier (1) selon la revendication 1, **caractérisé en ce que** la plaque de fond (9) est une pièce découpée.

3. Boîtier (1) selon l'une des revendications 1 ou 2, **caractérisé en ce que** l'insert perforé (5) est un composant coudé de la plaque de fond (9).

4. Boîtier (1) selon l'une des revendications 1, 2 ou 3, **caractérisé en ce que** l'appareil à haute fréquence est un tuner de télévision pour véhicules automobiles dans la gamme des fréquences au-dessus de 100 MHz.
